# EUROPEAN PATENT SPECIFICATION

(11) **EP 2 963 691 B1**
(45) Date of publication and mention of the grant of the patent: **16.10.2019**
(21) Application number: 14175329.3
(22) Date of filing: 01.07.2014
(51) Int. Cl.: H01L 31/0747

(54) **Solar cell**
Solarzelle
Cellule solaire

(43) Date of publication of application: 06.01.2016
(73) Proprietor: Meyer Burger (Germany) GmbH, 09337 Hohenstein-Ernstthal (DE)
(72) Inventor: Strahm, Benjamin, 1429 Giez (CH); Legradic, Boris, 1400 Yverdon-les-Bains (CH); Meixenberger, Jérôme, 2517 Diesse (CH); Lachenal, Damien, 2022 Bevaix (CH); Papet, Pierre, 2068 Hauterive (CH)
(74) Representative: Steiniger, Carmen

(56) References cited:
- EP-A1- 2 669 952
- US-A1- 2011 139 226
- US-A1- 2012 085 398
- US-A1- 2012 318 336
- US-A1- 2013 180 578

## Description

The present invention relates to a solar cell having a front or sunny side for light incidence and a back side opposite to the front side, said solar cell comprising: a crystalline semiconductor substrate of a first conductivity type or a second conductivity type being opposite to the first conductivity type; a front side passivating region formed by at least one passivating layer and at least one conductive layer of the first conductivity type; a back side passivating region formed by at least one passivating layer and at least one conductive layer of the second conductivity type; a front side contact formed by at least one front side conductive material and by front side electrical contacts formed on top of the front side conductive material; at least one front side light coupling layer on the front side of the solar cell; a back side contact being opposite the front side contact and being formed by at least one back side conductive material and at least one back side electrical contact formed thereon.

A solar cell of the mentioned type is known, for instance, from the document EP 2 662 900 A1. Such solar cells are generally called as silicon hetero junction solar cells. The solar cell described in the document EP 2 662 900 A1 comprises at its front side, on a single crystal silicon substrate of n-type, a layer stack of an intrinsic thin film of i-type amorphous silicon, an amorphous thin film of conductive p-type silicon, a thin transparent conductive oxide layer (TCO) of indium tin oxide (ITO), an insulating layer of, for instance, silicon nitride and a collecting electrode structure being electrically connected to the TCO layer laying by an electric pathway created through the insulating layer. By the transparent conductive oxide layer of the known solar cell, the charge carriers generated in the space charge region between the silicon substrate and the amorphous conductive silicon thin film are collected and transferred to the collecting electrode structure of the solar cell. The electrical conductivity of the transparent oxide layer is, therefore, indispensible. A major drawback of the TCO layer at the front side of the known solar cell is, however, that it absorbs part of the incoming light and does not serve as perfect anti-reflective coating for the solar cell as the insulating layer provided on top of the TCO layer does.

The document EP 2 669 952 A1 discloses a crystalline heterojunction solar cell having a front side emitter and a stack of at least two transparent conductive layers (TCO layers) formed on the emitter to enhance the efficiency of the solar cell in comparison to solar cells with only one front TCO layer. The stack of TCO layers consists of a combination of highly transparent and highly conductive materials in order, on the one hand, to increase the current density with one kind of TCO material and, on the other hand, to decrease the contact resistance with the front metallization with another kind of TCO material.

It is therefore the object of the present invention to provide a solar cell of the above mentioned type with a lower light absorption and better anti-reflective property at its front or sunny side.

This object is solved by a solar cell of the above mentioned type, wherein the at least one front side conductive material is thinner in regions between and/or besides the front side electrical contacts than in regions below the front side electrical contacts.

The present invention proposes to omit or to remove, at least partially, the front side conductive material in the regions between and/or besides the front side electrical contacts, that is in those regions where the front side conductive material does not serve as direct electrical "bridge" between the conductive layer of the front side passivating region and the front side electrical contacts of the solar cell. This structure has the advantage that although there is a good electrical connection between the front side passivating region and the front side electrical contacts by the conductive material formed there between, there is lower light absorption in the regions between and/or besides the front side electrical contacts due to the omitted conductive material. Moreover, the lower the thickness of the conductive material in the regions between and/or besides the front side electrical contacts, the more predominantly the anti-reflective property of the solar cell is determined in these regions by the material properties of the at least one light coupling layer. For instance, said at least one light coupling layer can be an electrically insulating layer such as a silicon nitride layer resulting in a very low light reflection. On the light incident side the light coupling layer might also be referred to as antireflective layer.

The reduction of parasitic absorption and reflection of photons with the solar cell of the present invention leads to a significant increase of the photo-generated current and, therefore, of the final output power of the solar cell and of solar cell modules manufactured on the base of the solar cell of the present invention. Moreover, the present invention allows a substitution of expensive transparent conductive material, such as indium based transparent conductive oxide, by low cost dielectric(s) such as silicon nitride (SiNₓ). Accordingly, with the present invention the cell manufacturing costs can be decreased.

In the new cell structure of the solar cell of the present invention with reduced thickness of the front side conductive material, the lateral transport of photo-generated carriers can be pushed into the bulk material of the crystalline semiconductor substrate rather than in the front side conductive material without electrical collection losses since the surface recombination velocity of crystalline semiconductor substrates produced with contemporary standards is very low. Therefore, the solar cell of the present invention is especially well adapted to cells where the emitter, such as a boron doped amorphous silicon layer, is placed at the back side of the silicon hetero junction cell when an n-type semiconductor substrate is used.

In a favorable embodiment of the present invention, the at least one front side conductive material is absent in the regions between and/or besides the front side electrical contacts and only located in the regions below the front side electrical contacts. In that embodiment, the anti-reflective characteristics of the solar cell in the regions between and/or besides the front side electrical contacts are only determined by the material properties of the at least one light coupling layer, since the conductive material is fully omitted in these regions. The conductive material is only present directly between the conductive layer of the front side passivating region and the front side electrical contacts, which regions cover a much smaller area than the regions between and/or besides the front side electrical contacts. This leads to the effect that the solar cell can be provided with nearly perfect anti-reflection properties. In addition, in said embodiment, the light absorption can be minimized in the regions between and/or besides the front side electrical contacts, too.

In an advantageous embodiment of the present invention, the at least one back side conductive material has a locally increased thickness in regions, wherein at least one back side light coupling layer is provided only between these regions of increased thickness. That is, that in embodiments of the present invention in which the at least one back side electrical contact comprises a pattern of back side electrical contacts, the at least one back side conductive material is thinner in regions between and/or besides the back side electrical contacts than in regions below the back side electrical contacts. In this embodiment of the invention, the bad influence of the back side conductive material on the anti-reflection properties of the solar cell is decreased by replacing at least a part of the back side conductive material by the at least one back side light coupling layer. In this embodiment, the effects described above with reference to the front side of the solar cell are also applied on its back side.

The anti-reflective properties of the solar cell of the present invention can be further increased if, in a specific variant of the above mentioned embodiment of the invention, the at least one back side conductive material is not provided under the at least one back side light coupling layer. That is, that in embodiments of the invention in which the at least one back side electrical contact comprises a pattern of back side electrical contacts and at least one back side light coupling layer is formed on the back side of the solar cell, the at least one back side conductive material is absent between the back side electrical contacts and only located in the regions below the back side electrical contacts.

A further enhancement of the current gain of the solar cell of the present invention can be achieved if, in another embodiment of the invention, the at least one conductive layer is thinner in regions between and/or besides the front side electrical contacts than in regions below the front side electrical contacts; and/or the at least one conductive layer is thinner in regions between and/or besides the back side electrical contacts than in regions below the back side electrical contacts; and/or the at least one conductive layer is thinner in regions between and/or besides regions of locally increased thickness of the at least one back side conductive material than in regions below said regions of locally increased thickness.

Favorably, but not unconditionally, the material of the at least one front side light coupling layer and/or the material of the at least one back side light coupling layer is chosen from at least one material of a group of materials comprising SiNₓ, SiOₓ, SiOₓN_{y}, AlOₓ, AlNₓ, TiOₓ, MgFₓ, a conductive oxide, a layer containing nanoparticles, or a combination of at least two of said materials.

Further favorably, but not unconditionally, the material of the front side electrical contacts and/or the material of the back side electrical contacts comprises at least one electrical conductive oxide, at least one metal, at least one metallic alloy, at least one of a conductive compound or a combination of at least two of said conductive materials.

Besides the advantages mentioned above, the present invention offers the possibility to select a more appropriate material for forming the conductive material between the conductive layer of the passivating region and the front or the back side contact, that is, the metallization of the solar cell. For instance, the front side conductive material and/or the back side conductive material can be a metal, a metal alloy or a transparent conductive oxide. The front side conductive material and/or the back side conductive material can be applied by physical vapor deposition, chemical vapor deposition, an ink-jet technology or a screen printing technology or by another suitable method.

In an optional embodiment of the present invention, the at least one front side conductive material and/or the at least one back side conductive material in regions between and/or besides the front side electrical contacts and/or the back side electrical contacts has a thickness between 0 and 150 nm.

According to a particular embodiment of the present invention, the at least one front side conductive material and/or the at least one back side conductive material in regions between and/or besides the front side electrical contacts and/or the back side electrical contacts has a thickness between 0 and 70 nm.

In an especial embodiment of the present invention, the at least one front side conductive material and/or the at least one back side conductive material in regions between and/or besides the front side electrical contacts and/or the back side electrical contacts has a thickness between 0 and 30 nm.

Preferred embodiments of the present invention, their structure and advantages are shown in the figures wherein
- Fig. 1: schematically shows an embodiment of the solar cell of the present invention with locally a reduced thickness of a front side conductive material of the solar cell;
- Fig. 2: schematically shows a further embodiment of the solar cell of the present invention wherein the front side conductive material is only situated under front side electrical contacts and wherein a back side conductive material has a locally reduced thickness and wherein a back side electrical contact pattern is provided only on regions of the back side conductive material with non-reduced thickness;
- Fig. 3: schematically shows a next embodiment of the solar cell of the present invention being similar to the solar cell of Fig. 2 but having a back side electrical contact layer extending over the whole back surface of the solar cell;
- Fig. 4: schematically shows a yet further embodiment of the solar cell of the present invention wherein the front side conductive material is only situated under front side electrical contacts and the back side conductive material is only situated under the back side electrical contacts; and
- Fig. 5: schematically shows another embodiment of the solar cell of the present invention wherein the thickness of a conductive layer of a front side passivating region as well as the thickness of a conductive layer of a back side passivating region are reduced in regions between and besides the front side electrical contacts and the back side electrical contacts, respectively, in comparison to the regions below the front side electrical contacts and the back side electrical contacts, respectively.

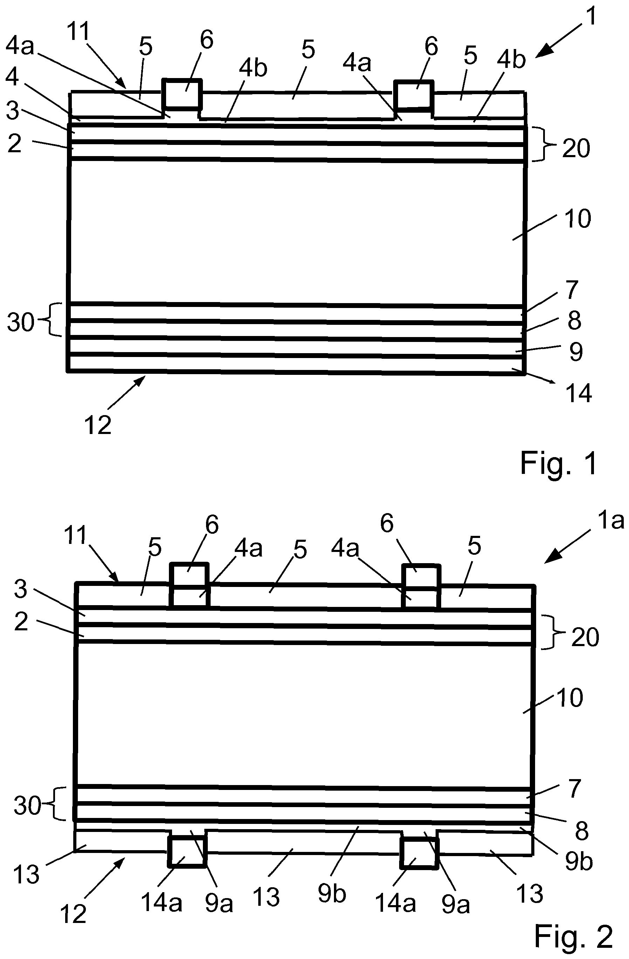

Fig. 1 schematically shows a solar cell 1 in accordance with an embodiment of the present invention. The solar cell 1 has a front side 11 for light incidence and a back side 12 being opposite to the front side 11.

The solar cell 1 comprises a semiconductor substrate 10 of a first conductivity type. In the embodiment shown, the semiconductor substrate 10 is of crystalline n-type silicon. In other non-shown embodiments of the present invention, the semiconductor substrate 10 can also be of a second conductivity type being contrary to the first conductivity type.

On the side of the semiconductor substrate 10 directed to the front side 11, a front side passivating region 20 is formed. The front side passivating region 20 comprises in the embodiment shown a passivating layer 2 and a conductive layer 3 of the first conductivity type. In other non-shown embodiments of the present invention, the front side passivating region 20 can consist of more than two layers, such as more than one passivating layer 2 and/or more than one conductive layer 3. In the embodiment shown, the passivating layer 2 is an intrinsic silicon layer and the conductive layer 3 is an amorphous silicon layer of n-type.

On the front sided surface of the conductive layer 3, a front side contact of the solar cell 1 is formed. The front side contact comprises in the embodiment shown a front side conductive material 4 and a pattern of front side electrical contacts 6 formed on top of the front side conductive material 4. The front side electrical contacts 6 are designed to extract a photo-generated electrical current up to a non-shown solar cell interconnection. The front side electrical contacts 6 are formed from silver in the embodiment shown. In other embodiments of the present invention, the front side electrical contacts 6 can also be of another material with very good electrical conductivity such as galvanically deposited copper.

In the solar cell 1 of Fig. 1, the front side conductive material 4 is a transparent conductive oxide (TCO) layer, such as an indium tin oxide (ITO) layer. In other non-shown embodiments of the present invention, the front side conductive material 4 can also be of another conductive material having a transparency being much lower than the transparency of an ITO layer, such as at least one metal or a low cost TCO. The front side conductive material 4 can be applied with different methods, for instance, by a physical vapor deposition, a chemical vapor deposition, an ink-jet method or a screen printing technology. This is possible in the present invention due to the reduced thickness of the front side conductive material 4 in regions 4b between and/or besides the front side electrical contacts 6 in comparison with regions 4a directly below the front side electrical contacts 6. That is, in the regions 4a situated under the front side electrical contacts 6, the front side conductive material 4 is thicker than in the regions 4b besides the regions 4a. In this context, the term "besides" means a region of the same front side conductive material 4 being on the left and/or the right side of the corresponding other region in the horizontal extension of the solar cell 1 if the structure of the solar cell 1 is considered as it is shown schematically in Fig. 1.

The different thickness of the front side conductive material 4 can be the result of a homogeneous deposition of the front side conductive material 4, followed by an etch process, such as a wet-chemical etch process, using a mask material, such as a wax or a hot melt, above the front side electrical contacts 6. Alternately, it is also possible to deposit the front side conductive material 4 through a mask.

The surface of the front side conductive material 4 is covered in the regions between and besides the front side electrical contacts with a front side light coupling layer 5. In other non-shown embodiments of the present invention, there can also more than one front side light coupling layers 5 be used. In the example shown, the front side light coupling layer 5 is of silicon nitride. In other embodiments of the present invention, the front side light coupling layer 5 can also be of SiOₓ, SiOₓN_{y}, AlOₓ, AlNₓ, TiOₓ, MgFₓ, a conductive oxide, a layer containing nanoparticles, or of a combination of at least two of the aforesaid materials, including SiNₓ.

On the side of the semiconductor substrate 10 directed to the back side 12 of the solar cell 1, a back side passivating region 30 is formed. The back side passivating region 30 comprises in the embodiment shown a passivating layer 7 and a conductive layer 8 of the second conductivity type. In other non-shown embodiments of the present invention, the front side passivating region 30 can consist of more than two layers, such as more than one passivation layer 7 and/or more than one conductive layer 8. In the embodiment shown, the passivating layer 7 is an intrinsic silicon layer and the conductive layer 8 is an amorphous silicon layer of p-type.

On the back sided surface of the conductive layer 8, a back side contact of the solar cell 1 is formed. The back side contact comprises in the embodiment shown a back side conductive material 9 and a back side electrical contact 14 formed in the embodiment shown as a continuous layer on top of the back side conductive material 9. The back side conductive material 9 can be a transparent conductive material such as an ITO layer, but can also be of another conductive material having a transparency being lower than the transparency of an ITO layer, such as at least one metal or a low cost TCO. The back side conductive material 9 can be applied with different methods, for instance, with a physical vapor deposition, by an ink-jet method or by a screen printing technology.

Fig. 2 schematically shows a solar cell 1a in accordance with another embodiment of the present invention. In Fig. 2 as well as in the following figures, same reference signs are used to indicate same or similar details of the present invention. The description of these details, which has already been made above with reference to the embodiment shown in Fig. 1 can also be applied to the corresponding details of the invention in the other embodiments of the invention shown in the following figures.

In comparison to the solar cell 1 of Fig. 1, in the solar cell 1a of Fig. 2 the front side conductive material 4 is absent in the regions 4b between and besides the front side electrical contacts 6 and is only located in the regions 4a below the front side electrical contacts 6.

Furthermore, the solar cell 1a comprises on its back side 12, instead of the continuous back side electrical contact layer 14 of the solar cell 1, a pattern of back side electrical contacts 14a.

The back side conductive material 9 of the solar cell 1a is thinner in regions 9b between and besides the back side electrical contacts 14a than in regions 9a below the back side electrical contacts 14a.

The back sided surface of the back side conductive material 9 of the solar cell 1a is covered with a back side light coupling layer 13 between the back side electrical contacts 14a. In other non-shown embodiments of the present invention, there can also be used more than one back side light coupling layers 13. In the example shown, the back side light coupling layer 13 is of silicon nitride. In other embodiments of the present invention, the back side light coupling layer 13 can also be of SiOₓ, SiOₓN_{y}, AlOₓ, AlNₓ, TiOₓ, MgFₓ, a conductive oxide, a layer containing nanoparticles, or of a combination of at least two of the aforesaid materials, including SiNₓ.

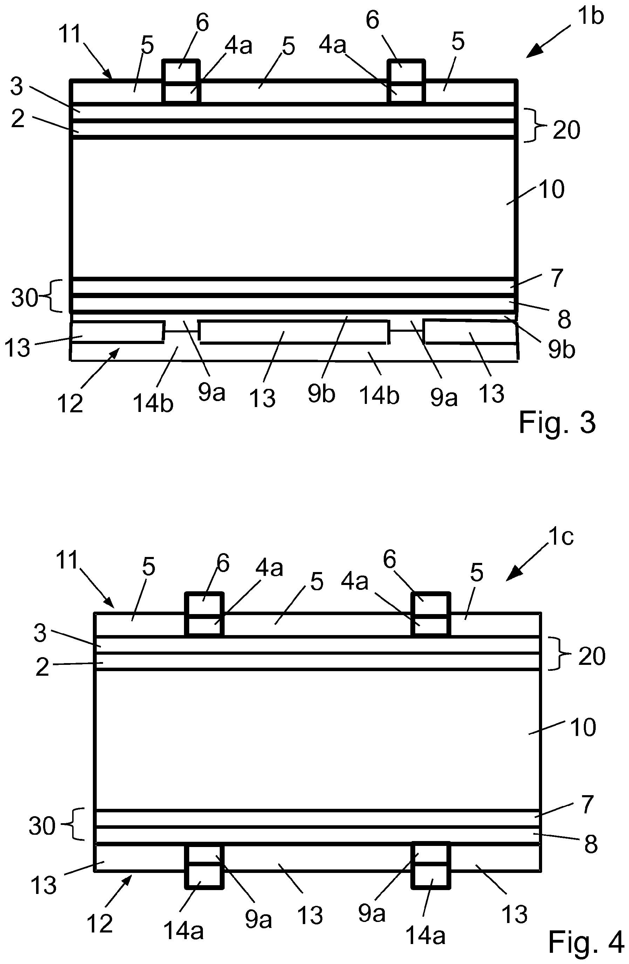

A further variation of the present invention is demonstrated in Fig. 3 showing a solar cell 1b being similar to the solar cell 1a of Fig. 2. In contrast to the solar cell 1a, the solar cell 1b of Fig. 3 comprises a back side contact layer 14b extending at least partially over the back surface of the solar cell 1b. That is, the back side electrical contact 14b is applied also between locally thicker regions 9a of the back side conductive material 9 and extends also over the back side light coupling layer 13. This gives in this variation of the invention an improved reflectivity at the back side 12 of the solar cell 1b and will hence to improve the efficiency of the solar cell 1b.

Fig. 4 schematically shows a solar cell 1c in accordance with a further embodiment of the present invention.

In the solar cell 1c, the front side conductive material 4 is absent in the regions 4b between and besides the front side electrical contacts 6 and is only located in the regions 4a below the front side electrical contacts 6. In the same way, the back side conductive material 9 is absent in the regions 9b between and besides the back side electrical contacts 14a and is only located in the regions 9a below the back side electrical contacts 14a.

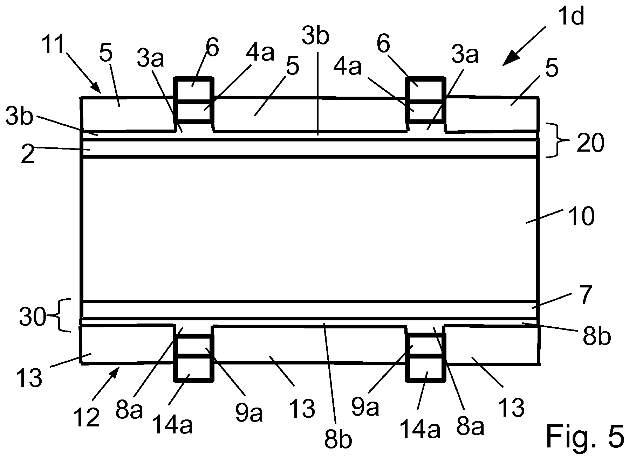

Fig. 5 schematically shows a solar cell 1d in accordance with yet another embodiment of the present invention.

As in the solar cell 1c of Fig. 4, in the solar cell 1d the front side conductive material 4 is absent in the regions 4b between and besides the front side electrical contacts 6 and is only located in the regions 4a below the front side electrical contacts 6. In the same way, the back side conductive material 9 is absent in the regions 9b between and besides the back side electrical contacts 14a and is only located in the regions 9a below the back side electrical contacts 14a.

Moreover, the conductive layer 3 on the front side 11 of the solar cell 1d is thinner in regions 3b between and besides the front side electrical contacts 6 than in regions 3a below the front side electrical contacts 6. In addition, the at least one conductive layer 8 on the back side 12 of the solar cell 1d is thinner in regions 8b between and besides the back side electrical contacts 14a than in regions 8a below the back side electrical contacts 14a.

## Claims

1. Solar cell (1, 1a, 1b, 1c) having a front side (11) for light incidence and a back side (12) opposite to the front side (11), said solar cell (1, 1a, 1b, 1c) comprising:
- a crystalline semiconductor substrate (10) of a first conductivity type or a second conductivity type being opposite to the first conductivity type;
- a front side passivating region (20) formed by at least one passivating layer (2) and at least one conductive layer (3) of the first conductivity type;
- a back side passivating region (30) formed by at least one passivating layer (7) and at least one conductive layer (8) of the second conductivity type;
- a front side contact formed on the front sided surface of the conductive layer (3) of the passivating region (20) by a front side transparent conductive oxide material (4) and by a pattern of front side electrical contacts (6) formed on top of the front side conductive material (4);
- at least one front side light coupling layer (5) on the front side (11) of the solar cell (1, 1a, 1b, 1c);
- a back side contact being opposite the front side contact and being formed by a back side conductive material (9) and at least one back side electrical contact (14, 14a, 14b) formed thereon,
**characterized in that** the front side transparent conductive oxide material (4) is thinner in regions (4b) between and/or besides the front side electrical contacts (6) than in regions (4a) below the front side electrical contacts (6), wherein the front side transparent conductive oxide material (4) in regions (4b) between and/or besides the front side electrical contacts (6) has a thickness between 0 and 30 nm.

2. Solar cell of claim 1, **characterized in that** the front side transparent conductive oxide material (4) is absent in the regions (4b) between and/or besides the front side electrical contacts (6) and only located in the regions (4a) below the front side electrical contacts (6).

3. Solar cell of at least one of the preceding claims, **characterized in that** the back side conductive material (9) is one back side conductive material (9) and has a locally increased thickness in regions (9a), wherein at least one back side light coupling layer (13) is provided only between these regions (9a) of increased thickness.

4. Solar cell of claim 3, **characterized in that** the back side conductive material (9) is not provided under the at least one back side light coupling layer (13).

5. Solar cell of claim 3 or 4, **characterized in that** the at least one back side electrical contact comprises a pattern of back side electrical contacts (14a), said back side electrical contacts (14a) being provided only on that regions (9a) of the back side conductive material (9) with the locally increased thickness.

6. Solar cell of claim 3 or 4, **characterized in that** the at least one back side electrical contact comprises a back side electrical contact layer (14b) extending at least partially over the at least one back side light coupling layer (13)

7. Solar cell of at least one of the preceding claims, **characterized in that** the at least one conductive layer (3) is thinner in regions (3b) between and/or besides the front side electrical contacts (6) than in regions (3a) below the front side electrical contacts (6).

8. Solar cell of at least one of the preceding claims, **characterized in that** the material of the front side electrical contacts (6) and/or the material of the back side electrical contacts (14, 14a) comprises at least one electrical conductive oxide, at least one metal, at least one metallic alloy, at least one of a conductive compound or a combination of at least two of said conductive materials.

9. Solar cell of at least one of the preceding claims, **characterized in that** the material of the at least one front side light coupling layer (5) is chosen from at least one material of a group of materials comprising SiNₓ, SiOₓ, SiOₓN_{y}, AlOₓ, AlNₓ, TiOₓ, MgFₓ, a conductive oxide, a layer containing nanoparticles, or a combination of at least two of said materials.

10. Solar cell of at least one of the preceding claims, **characterized in that** the back side conductive material (9) is chosen from a group of materials comprising transparent conductive oxide(s), metal(s), metal alloy(s) or conductive oxide(s).

## Patentansprüche

1. Solarzelle (1, 1a, 1b, 1c) mit einer Vorderseite (11) für Lichteinfall und einer der Vorderseite (11) gegenüber liegenden Rückseite (12), wobei die Solarzelle (1, 1a, 1b, 1c)
- ein kristallines Halbleitersubstrat (10) eines ersten Leitungstyps oder eines zweiten zu dem ersten Leistungstyp entgegengesetzten Leitungstyp;
- einen vorderseitigen Passivierungsbereich (20), der von wenigstens einer Passivierungsschicht (2) und wenigstens einer elektrisch leitfähigen Schicht (3) des ersten Leitungstyps ausgebildet ist;
- einen rückseitige Passivierungsbereich (30), der von wenigstens von einer Passivierungsschicht (7) und wenigstens einer elektrisch leitfähigen Schicht (8) des zweiten Leitungstyps ausgebildet ist;
- einen vorderseitigen Kontakt, der auf der vorderseitigen Oberfläche der elektrisch leitfähigen Schicht (3) des Passivierungsbereiches (20) durch ein vorderseitiges transparentes elektrisch leitfähiges Oxidmaterial (4) und durch eine Struktur vorderseitiger elektrischer Kontakte (6), die auf dem vorderseitigen elektrisch leitfähigen Material (4) ausgebildet sind, ausgebildet ist;
- wenigstens eine vorderseitige Lichtkopplungsschicht (5) auf der Vorderseite (11) der Solarzelle (1, 1a, 1b, 1c);
- ein dem vorderseitigen Kontakt gegenüberliegender rückseitiger Kontakt, der aus einem rückseitigen elektrisch leitfähigen Material (9) und wenigstens einem darauf ausgebildeten rückseitigen elektrischen Kontakt (14, 14a, 14b) ausgebildet ist,
umfasst,
**dadurch gekennzeichnet,**
**dass** das vorderseitige transparente elektrisch leitfähige Oxidmaterial (4) in Bereichen (4b) zwischen und/oder neben den vorderseitigen elektrischen Kontakten (6) dünner ist als in Bereichen (4a) unter den vorderseitigen elektrischen Kontakten (6), wobei das vorderseitige transparente elektrisch leitfähige Oxidmaterial (4) in Bereichen (4b) zwischen und/oder neben den vorderseitigen elektrischen Kontakten (6) eine Dicke zwischen 0 und 30 nm aufweist.

2. Solarzelle nach Anspruch 1, **dadurch gekennzeichnet, dass** das vorderseitige transparente elektrisch leitfähige Oxidmaterial (4) in den Bereichen (4b) zwischen und/oder neben den vorderseitigen elektrischen Kontakten (6) fehlt und sich nur in den Bereichen (4a) unter den vorderseitigen elektrischen Kontakten (6) befindet.

3. Solarzelle nach wenigstens einem der vorhergehenden Ansprüche, **dadurch gekennzeichnet, dass** das rückseitige elektrisch leitfähige Material (9) ein rückseitiges elektrisch leitfähiges Material (9) ist und in Bereichen (9a) eine örtlich größere Dicke aufweist, wobei wenigstens eine rückseitige Lichtkopplungsschicht (13) nur zwischen diesen Bereichen (9a) mit größerer Dicke vorgesehen ist.

4. Solarzelle nach Anspruch 3, **dadurch gekennzeichnet, dass** das rückseitige elektrisch leitfähige Material (9) unter der wenigstens einen rückseitigen Lichtkopplungsschicht (13) nicht vorgesehen ist.

5. Solarzelle nach Anspruch 3 oder 4, **dadurch gekennzeichnet, dass** der wenigstens eine rückseitige elektrische Kontakt eine Struktur von rückseitigen elektrischen Kontakten (14a) aufweist, wobei die rückseitigen elektrischen Kontakte (14a) nur auf den Bereichen (9a) des rückseitigen elektrisch leitfähigen Materials (9) mit örtlich größerer Dicke vorgesehen sind.

6. Solarzelle nach Anspruch 3 oder 4, **dadurch gekennzeichnet, dass** der wenigstens eine rückseitige elektrische Kontakt eine rückseitige elektrische, sich wenigstens teilweise über die wenigstens eine rückseitige Lichtkopplungsschicht (13) erstreckende Kontaktschicht (14b) aufweist.

7. Solarzelle nach wenigstens einem der vorhergehenden Ansprüche, **dadurch gekennzeichnet, dass** die wenigstens eine elektrisch leitfähige Schicht (3) in Bereichen (3b) zwischen und/oder neben den vorderseitigen elektrischen Kontakten (6) dünner ist als in Bereichen (3a) unter den vorderseitigen elektrischen Kontakten (6).

8. Solarzelle nach wenigstens einem der vorhergehenden Ansprüche, **dadurch gekennzeichnet, dass** das Material der vorderseitigen elektrischen Kontakte (6) und/oder das Material der rückseitigen elektrischen Kontakte (14, 14a) wenigstens ein elektrisch leitfähiges Oxid, wenigstens ein Metall, wenigstens eine metallische Legierung, wenigstens eine elektrisch leitfähige Verbindung oder eine Kombination von wenigstens zwei dieser elektrisch leitfähigen Materialien aufweist.

9. Solarzelle nach wenigstens einem der vorhergehenden Ansprüche, **dadurch gekennzeichnet, dass** das Material der wenigstens einen vorderseitigen Lichtkopplungsschicht (5) aus wenigstens einem Material einer SiNₓ, SiOₓ, SiOₓN_{y}, AlOₓ, AlNₓ, TiOₓ, MgFₓ, ein elektrisch leitfähiges Oxid, eine Schicht mit Nanopartikeln oder eine Kombination von wenigstens zwei dieser Materialien aufweisenden Materialgruppe ausgewählt wird.

10. Solarzelle nach wenigstens einem der vorhergehenden Ansprüche, **dadurch gekennzeichnet, dass** das rückseitige elektrisch leitfähige Material (9) aus einer transparente(s) leitfähige(s) Oxid(e), Metall(e), metallische Legierung(en) oder leitfähige(s) Oxid(e) aufweisenden Materialgruppe ausgewählt wird.

## Revendications

1. Cellule solaire (1, 1a, 1b, 1c) ayant une face avant (11) pour l'incidence de la lumière et une face arrière (12) opposée à la face avant (11), ladite cellule solaire (1, 1a, 1 b, 1 c) comprenant:
- un substrat semi-conducteur cristallin (10) d'un premier type de conductivité ou d'un second type de conductivité opposé au premier type de conductivité;
- une région de passivation de face avant (20) formée par au moins une couche de passivation (2) et au moins une couche conductrice (3) du premier type de conductivité;
- une région de passivation de face arrière (30) formée par au moins une couche de passivation (7) et au moins une couche conductrice (8) du second type de conductivité;
- un contact de face avant formé sur la face avant de la couche conductrice (3) de la région de passivation (20) par au moins un matériau d'oxyde transparent conducteur de face avant (4) et par une structure de contacts électriques de face avant (6) formés sur la partie supérieure du matériau conducteur de face avant (4);
- au moins une couche de couplage de lumière de face avant (5) sur la face avant (11) de la cellule solaire (1, 1a, 1b, 1c);
- un contact de face arrière opposé au contact de face avant et formé par au moins un matériau conducteur de face arrière (9) et au moins un contact électrique de face arrière (14, 14a, 14b) formé sur celui-ci,
**caractérisée en ce que**
le matériau d'oxyde transparent conducteur de face avant (4) est plus mince dans les zones (4b) situées entre et / ou à côté des contacts électriques de face avant (6) que dans les zones (4a) situées au-dessous des contacts électriques de face avant (6), le matériau d'oxyde transparent conducteur de face avant (4) dans les zones (4b) étant situées entre et / ou à côté des contacts électriques de face avant (6) présente une épaisseur entre 0 et 30 nm.

2. Cellule solaire selon la revendication 1, **caractérisée en ce que** le matériau d'oxyde transparent conducteur de face avant (4) est absent dans les zones (4b) situées entre et / ou à côté des contacts électriques de face avant (6) et est situé uniquement dans les zones (4a) au-dessous des contacts électriques de face avant (6).

3. Cellule solaire selon au moins l'une des revendications précédentes, **caractérisée en ce que** le matériau conducteur de face arrière (9) est un matériau conducteur de face arrière (9) et présente une épaisseur localement augmentée dans les zones (9a), au moins une couche de couplage de lumière de face arrière (13) étant prévue seulement entre ces régions (9a) d'épaisseur augmentée.

4. Cellule solaire selon la revendication 3, **caractérisée en ce que** le matériau conducteur de face arrière (9) n'est pas prévu sous la au moins une couche de couplage de lumière de face arrière (13).

5. Cellule solaire selon la revendication 3 ou 4, **caractérisée en ce que** le au moins un contact électrique de face arrière comprend une structure de contacts électriques de face arrière (14a), lesdits contacts électriques de face arrière (14a) étant prévus uniquement sur les régions (9a) du matériau conducteur de face arrière (9) de l'épaisseur localement augmentée.

6. Cellule solaire selon la revendication 3 ou 4, **caractérisée en ce que** le au moins un contact électrique de face arrière comprend une couche de contact électrique de face arrière (14b) s'étendant au moins partiellement sur la au moins une couche de couplage de lumière de face arrière (13).

7. Cellule solaire selon au moins l'une des revendications précédentes, **caractérisée en ce que** la au moins une couche conductrice (3) est plus mince dans les régions (3b) situées entre et / ou à côté des contacts électriques de face avant (6) que dans les régions (3a) situées au-dessous des contacts électriques de face avant (6).

8. Cellule solaire selon au moins l'une des revendications précédentes, **caractérisée en ce que** le matériau des contacts électriques de face avant (6) et / ou le matériau des contacts électriques de face arrière (14, 14a) comprend au moins un oxyde conducteur électrique, au moins un métal, au moins un alliage métallique, au moins un composé conducteur ou une combinaison d'au moins deux desdits matériaux conducteurs.

9. Cellule solaire selon au moins l'une des revendications précédentes, **caractérisée en ce que** le matériau de la au moins une couche de couplage de lumière de face avant (5) est choisi parmi au moins un matériau d'un groupe de matériaux comprenant SiNₓ, SiOₓ, SiOₓN_{y}, AlOₓ, AlNₓ, TiOₓ, MgFₓ, un oxyde conducteur, une couche contenant des nanoparticules ou une combinaison d'au moins deux desdits matériaux.

10. Cellule solaire selon au moins l'une des revendications précédentes, **caractérisée en ce que** le matériau conducteur de face arrière (9) est choisi parmi au moins un matériau d'un groupe de matériaux comprenant d'oxyde(s) conducteur(s) transparent(s), de(s) métal/métaux, d'alliage(s) métallique(s) ou d'oxyde(s) conducteur(s).
